# EUROPÄISCHE PATENTSCHRIFT

(11) **EP 1 602 882 B1**
(45) Veröffentlichungstag und Bekanntmachung des Hinweises auf die Patenterteilung: **23.12.2009**
(21) Anmeldenummer: 05010870.3
(22) Anmeldetag: 19.05.2005
(51) Int. Cl.: F24C 7/08, H03K 17/96

(54) **Sensoranordnung für eine pseudo-kontinuierliche Betätigung**
Sensor arrangement for a pseudo-continuous actuation
Arrangement de capteurs pour un actionnement pseudo-continue

(30) Priorität: 19.05.2004 DE 102004024835
(43) Veröffentlichungstag der Anmeldung: 07.12.2005
(60) Teilanmeldung: 09163613.4
(73) Patentinhaber: ZF Friedrichshafen AG, 88038 Friedrichshafen (DE)
(72) Erfinder: Türmer, Hubert, 91275 Auerbach (DE); Habenschaden, Josef, 92702 Kohlberg (DE)

(56) Entgegenhaltungen:
- EP-A- 1 273 851
- WO-A-85/04295
- US-A- 4 121 204
- US-A- 5 103 085
- US-A1- 2003 020 004
- US-A1- 2003 090 470

## Beschreibung

Die Erfindung bezieht sich auf eine Kochfeldsteuerung mit einer Mehrzahl von Infrarot-Sensoren, die längs einer Bedienlinie angeordnet sind.

Aus der Offenlegungsschrift DE 102 11 047 A1 ist eine Anordnung zum Steuern eines Kochfeldes bekannt. Das Bedienfeld weist neben einem Hauptschalter vier Infrarot-Berührungsschalter auf, die zum Einstellen der Leistungsstufe an vier verschiedenen Kochstellen der zugehörigen Kochplatte dienen. Dabei ist jeder Kochstelle einer der Infrarot-Berührungsschalter zugeordnet. Jeder der Berührungsschalter weist zwei Sensoren auf. Wenn der Nutzer den Sensor "Minus" berührt, so wird die Leistungsstufe der Kochstelle heruntergeschaltet. Wenn der Nutzer hingegen den Sensor "Plus" des Berührungsschalters berührt, so wird die Leistungsstufe hochgefahren. Jeder Infrarotsensor besteht aus einer Infrarotsendediode und einem Infrarotfototransistor.

Eine ähnliche Steuerungsbaugruppe gemäss der Gebrauchsmusterschrift DE 200 08 425 U1 weist für vier Herdplatten mindestens zehn Sensorelemente auf. Zum Erhöhen und Erniedrigen der Kochstufe einer Kochstelle sind -wie bei dem zuvor erwähnten Stand der Technik- jeweils Sensorelemente "Plus" und "Minus" vorgesehen. Jedes Sensorelement besteht aus einem Infrarot-Sender und einem für Infrarotlicht empfindlichen Empfänger, die auf einer Leiterplatte benachbart befestigt sind. Zur optischen Abschottung der mindestens zehn Sensorelemente voneinander dienen entweder einzelne Kunststoffrähmchen oder eine gemeinsame Matte.

Auch die aus den Abschnitten [0001] und [0002] der Druckschrift US 2003/0090470 A1 bekannte Verwendung von Infrarot-Sensorpaaren als Einzeltasten (und die zugehörige Ausrichtung der Infrarot-Lichtsender und Infrarot-Lichtempfänger "zueinander") sind in der vorliegenden Erfindung vörausgesetzt. Die Schrift sagt hingegen nichts aus über eine Gruppierung solcher Tasten zu einer funktionalen Bedienlinie. Es geht laut Absatz [0003], [0004] und [0005] stets um ein ungestörtes Betätigen einer einzigen Taste. Diese technische Lehre propagiert eine zeitselektive Ansteuerung, um eine Mehrfachbetätigung benachbarter Sensoren zu verhindern.

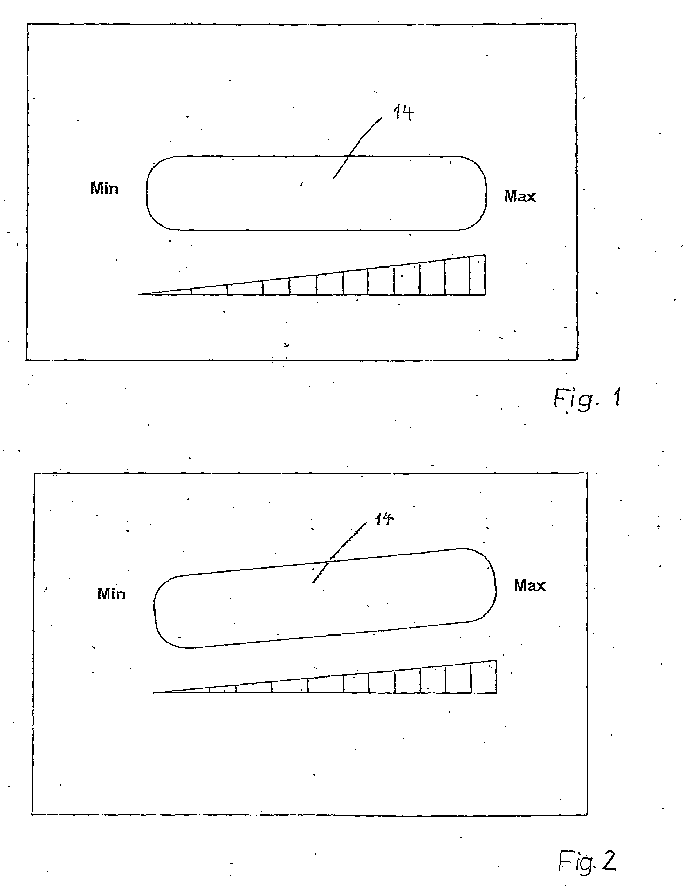

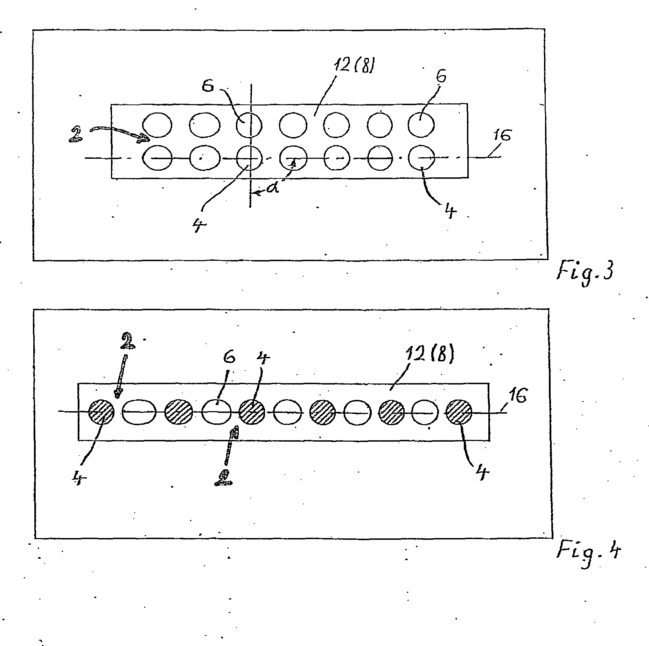

Gemäß Absatz [0022] können zwar jeweils vier Lichtsender und jeweils vier zugeordnete Lichtempfänger "längs einer Reihe" angeordnet sein. Das bedeutet jedoch nicht, dass diese vier Einzeltasten eine Bedienlinie bilden. Vielmehr geht es darum, die vier Tasten trotz eines minimalen Abstands getrennt zu berühren und zu bedienen. Eine gleichmäßige Ausrichtung der bekannten Sensorpaare würde deshalb in dem Stand der Technik gemäß US 2003/0090470A1 keine Rolle spielen. Von einer Ausrichtung eines IR-Fototransistors und einer IR-Sendediode als Paare mit jeweils gleicher Ausrichtung relativ zu einer Bedienlinie wird nichts angedeutet. Ferner sind die Anspruchsmerkmale aus dieser Schrift auch nicht zufällig bekannt. Weder der in Figur 1 dargestellte Schnitt durch die Reihe noch das in den Figuren 2 und 3 dargestellte Schema zeigen einen Grundriss, aus dem eine Winkelausrichtung von Paarachsen relativ zu einer Bedienlinie oder relativ zu einer Reihe entnehmbar wäre. Eine solche Darstellung einer Ausrichtung wäre auch nicht notwendig: Denn wenn aufgrund der genannten zeitselektiven Ansteuerung sowieso immer nur ein Transistor-Sensor-Paar in Betrieb ist, so ist die Anordnung der Paare untereinander oder relativ zueinander ohne Bedeutung.

Auch die Schrift EP 0 618 680 A1 zeigt keine auf Infrarotlicht basierende Bedienlinie, sondern eine Dreifachtastatur. Es handelt sich um eine optoelektronische Tastatur für ein industrielles Messinstrument. Bei dieser dreifachen Abfolge isolierter Einzeltasten werden Signale auf benachbarte Tasten, anders als bei Schiebereglern, als Störsignale empfunden und deshalb eliminiert. In Fig. 2 der EP 0 618 680 A1 ist eine Halterung für IR-Lichtsender, IR-Lichtempfänger und Abschirmungen der Dreifachtastatur dargestellt. Die Halterung ist bevorzugt ein Kunststoffteil, an das die Abschirmungen der Einzeltasten untereinander als gemeinsamer Steg angeformt sind.

Aus der Offenlegungsschrift DE 196 45 907 ist eine gattungsgemäße Vorrichtung zum Einstellen des Betriebszustands eines Kochfelds bekannt. Ausgehend von den oben beschriebenen "Touch-Sensoren" wird bemängelt, dass jede Leistungsstufe immer seriell zwischen einer aktuellen Leistungsstufe und einer gewünschten Leistungsstufe durchgeschaltet werden muss. Zur Abhilfe wird vorgeschlagen, für jede Kochstelle ein Bedienfeld mit jeweils acht Betätigungssensoren zum Steuern der Heizleistung (Kochstufe) nebeneinander anzuordnen. Offenbart sind eine lineare Anordnung, die einem Schiebeschalter entspricht, und eine kreisbogenförmige Anordnung, die einem Drehknebel entspricht. Ein gewünschter Betriebszustand wird dann eingestellt, wenn beginnend mit einem vorgegebenen Betätigungssensor als Startsensor nacheinander aufeinanderfolgende Betätigungssensoren bis zu einem Zielsensor mit dem Finger berührt werden.

Ein ähnlicher "Stellstreifen", der ebenfalls geradlinig oder bogenförmig oder kreisförmig verlaufen kann, ist aus der Offenlegungsschrift DE 101 33 135 A1 = EP 1 273 851 A2 bekannt. Die berührungsempfindlichen Sensoren können auf allen bekannten Prinzipien beruhen (kapazitiv, induktiv, optisch, thermisch, piezoelektrisch oder dgl.), ohne dass die Druckschrift Angaben über eine konstruktiv zweckmäßige Anordnung von optischen Sensoren auf einem "Stellstreifen" macht. Offenbart ist ein kapazitiver Stellstreifen, bei dem ein dielektrischer Träger metallische Sensorflächen trägt. Auch die Schrift US 4,121,204A offenbart lediglich eine Anordnung von kapazitiven Sensoren entlang einer Linie sowie eine zusätzliche Anordnung von Neonlampen entlang dieser Linie.

Ausgehend von Kochfeldsteuerungen mit einer Mehrzahl von Infrarotsensoren, die längs einer Bedienlinie angeordnet sind, besteht die Aufgabe der Erfindung darin, die Infrarot-Fototransistoren und die Infrarot-Sendedioden konstruktiv zweckmäßig entlang der Bedienlinie anzuordnen.

Diese Aufgabe wird nach dem Anspruch 1 dadurch gelöst, dass eine Mehrzahl von Infrarot-Fototransistoren und eine Mehrzahl von Infrarot-Sendedioden abwechselnd auf der Bedienlinie angeordnet sind und die Bedienlinie mit je einem Infrarot-Fototransistor abschließt.

Zweckmäßige konstruktive Weiterbildungen der Erfindung gehen aus den Unteransprüchen hervor.

Das Prinzip der Erfindung besteht darin, die Infrarot-Fototransistoren auf einer frei wählbaren und ergonomisch günstigen Bedienlinie anzuordnen und die Infrarot-Sendedioden auf der Bedienlinie so zu gruppieren, dass die Infrarot-Fototransistoren bei einer komplexen Fingerberührung gut ausgeleuchtet werden. Dabei müssen ein Fototransistor und eine IR-Sendediode nicht unbedingt ein festes Paar bilden. Eine schmale oder schlanke Bedienlinie wird erhalten, wenn die Leuchtdioden und die Fototransistoren abwechselnd auf der Bedienlinie angeordnet sind.

Ausführungsbeispiele der Erfindung werden anhand von Figuren 1 bis 5 erläutert. Es zeigen:
Figur 1 eine geradlinige, horizontale Betätigungsfläche einer erfindungsgemäßen Kochfeldsteuerung;
Figur 2 eine geradlinige, schräge Betätigungsfläche einer erfindungsgemäßen Kochfeldsteuerung;
Figur 3 ein unter der Betätigungsfläche ach Figur 1 angeordnetes Gehäuse nach einem nicht zur Erfindung gehörigen Beispiel, bei dem alle IR-Sensoren in einem Kunststoffteil gruppiert sind (Winkel α = 90° zur Bedienlinie);
Figur 4 ein unter der Betätigungsfläche nach Figur 1 angeordnetes Gehäuse nach einem Ausführungsbeispiel der Erfindung, bei dem die Elemente ebenfalls in einem Kunststoffteil gruppiert sind (jedoch Winkel α = 0° zur Bedienlinie);
Figur 5a beispielhaft eine direkte Anwahl einer Kochstufe;
Figuren 5b und 5c beispielhaft eine Erniedrigung der Kochstufe durch Überstreichen der Betätigungsfläche von rechts nach links.

In herkömmlichen, autarken Glaskeramikkochfeldern werden die Kochstufen der einzelnen Kochstellen meist durch so genannte Sensorschalter eingestellt. Hierbei ist eine Sensorfläche, die entsprechend auf der Glaskeramik optisch gekennzeichnet ist, durch den Benutzer zu betätigen, um entweder die Kochstufe zu erhöhen oder zu erniedrigen. Eine dauerhafte Betätigung bewirkt dabei eine kontinuierliche Veränderung der eingestellten Kochstufe z.B. von 0, 1, 2... bis 9. Nachteilig ist hierbei die lange Betätigungszeit, um von der niedrigsten zur höchsten Kochstufe und umgekehrt zu gelangen.

Zur Abhilfe wurde eine Sensoranordnung vorgeschlagen, die eine pseudokontinuierliche Betätigung ermöglicht, die einem Schieberegler nachempfunden ist. Diese Sensoranordnung wird erfindungsgemäß weiterentwickelt (Anspruch 1). Neben der Sensoranordnung wird eine Lichtleiteranordnung in einem Gehäuse definiert (Anspruch 5).

Die Figuren 1 und 2 zeigen zwei Beispiele für eine Betätigungsfläche 14. In diesen Fällen ist die Betätigungsfläche 14 geradlinig, d.h. ein Finger 18 kann zwischen den Werten MIN und MAX die Betätigungsfläche 14 geradlinig berühren. Auf einem der Betätigungsfläche 14 zugeordneten grafischen Symbol wird die nach Art eines Schiebereglers eingestellte Kochstufe angezeigt.

In Figur 1 ist die längs der Bedienlinie 16 liegende Betätigungsfläche 14 horizontal, in Figur 2 schräg ausgerichtet.

Bei den Figuren 3 und 4 sind alle Infrarotelemente 4,6 in einem Kunststoffteil 12 gruppiert, das mehrere Infrarotsendedioden 6 und Infrarotfototransistoren 4 sowie die zugehörigen Lichtleiter enthält. In beiden Fällen ist die Bedienlinie 16 eine horizontale Gerade wie in Figur 1, jedoch sind in Figur 3 die Infrarot-Sendedioden 6 und Infrarot-Fototransistoren 4 paarweise unter α = 90° angeordnet (hier nicht zur Erfindung gehörend), während in dem Ausführungsbeispiel nach Figur 4 die Infrarot-Sendedioden 6 um 90° in die Bedienlinie 16 hineingedreht sind und kein festes Paar mehr bilden. In Figur 4 wechselt jeweils eine Infrarot-Sendediode 6 mit einem Infrarot-Fototransistor 4 ab. Diese Anordnung wird auf jeder Seite mit einem Infrarot-Fototransistor 4 abgeschlossen.

In allen Fällen kann die Bedienlinie 16 auch schräg, bogenförmig oder geschwungen sein.

Die erfindungsgemäße Kochfeldsteuerung wird wie folgt bedient.

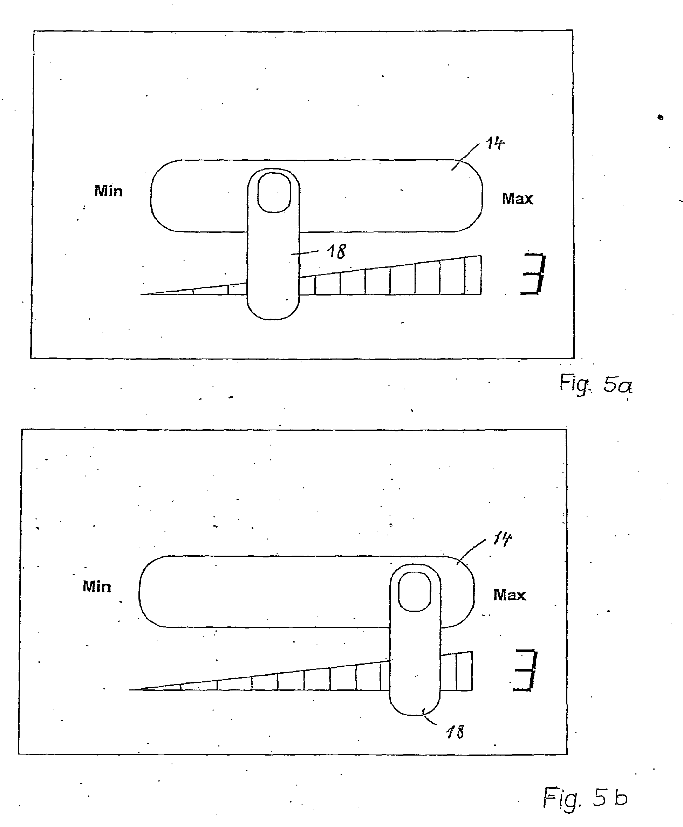

Es ist möglich, durch Betätigung eines bestimmten Bereiches der Betätigungsfläche 14 direkt eine Kochstufe anzuwählen, die diesem Bereich entspricht. Ist z. B die maximale Kochstufe, die eingestellt werden kann, "9" und es wird die Betätigungsfläche 14 im ersten Drittel berührt, so wird die Kochstufe "3" eingestellt. Diesen Vorgang der direkten Anwahl der Kochstufe "3" zeigt Figur 5a.

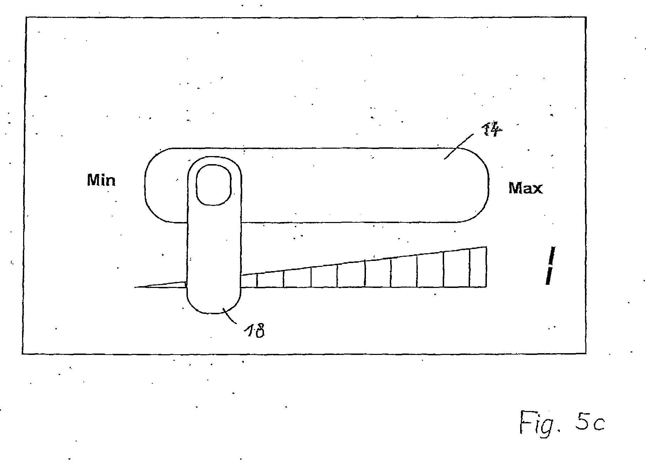

Es ist aber auch möglich, durch Überstreichen der Betätigungsfläche 14 die Kochstufe kontinuierlich zu verändern. Dabei bewirkt z.B. ein Überstreichen von links nach rechts eine Erhöhung und ein Überstreifen von rechts nach links eine Erniedrigung der eingestellten Kochstufe. Dabei muss der Start des Fingers 18 auf der Betätigungsfläche 14 nicht der gerade eingestellten Kochstufe entsprechen. Eine Fingerbewegung nach links zur Erniedrigung der Kochstufe ist beispielhaft in Figur 5b und Figur 5c dargestellt.

Auch ist es hierdurch möglich, die Kochstufe "0" anzuwählen, ohne die Betätigungsfläche 14 bis zur linken Begrenzungsfläche MIN zu überstreichen.

Die AUS-Position muss aus Gründen der Betriebssicherheit genau gekennzeichnet werden. Diese Kennzeichnung kann in der Betätigungsfläche 14 z.B. dadurch erfolgen, dass der linke Rand des Betätigungsfelds 14 durch ein AUS-Symbol hervorgehoben wird.

Durch eine Auswertung der Geschwindigkeit, mit der die Betätigungsfläche 14 überstrichen wird, ist es möglich, eine Änderung der Kochstufe schneller erfolgen zu lassen. Zum Beispiel kann eine schnelle Betätigung von rechts nach links als Panikreaktion gedeutet werden, weil das Kochgut überkocht oder anbrennt, und die Kochstufe wird entsprechend schnell erniedrigt. Andererseits kann ein langsames Überstreichen der Betätigungsfläche 14 als ein genaues Anwählen einer Kochstufe gedeutet werden und die Kochstufen wechseln entsprechend langsamer.

### Abkürzungen und Bezugsziffern

- IR: Infrarot
- N1: Anzahl der IR-Fototransistoren 4
- N2: Anzahl der IR-Sendedioden 6
- α: Winkelstellung eines IR-Sensors 2 relativ zur Bedienlinie 16
- 2: IR-Sensoren
- 4: IR-Fototransistoren
- 6: IR-Sendedioden
- 8: Gehäuse (Lichtleitsockel 10 oder Kunststoffteil 12)
- 10: Lichtleitsockel
- 12: Kunststoffteil
- 14: Betätigungsfeld
- 16: Bedienlinie
- 18: Finger

## Patentansprüche

1. Kochfeldsteuerung mit einer Mehrzahl von Sensoren (2) auf einer Bedienlinie (16);
**dadurch gekennzeichnet, dass** eine Mehrzahl (N1) von IR-Fototransistoren (4) und eine Mehrzahl (N2) von IR-Sendedioden (6) abwechselnd auf der Bedienlinie (16) angeordnet sind, und
die Bedienlinie (16) mit je einem IR-Fototransistor (4) abschließt.

2. Kochfeldsteuerung nach Anspruch 1, **dadurch gekennzeichnet, dass** die Bedienlinie (16) eine Gerade ist.

3. Kochfeldsteuerung nach Anspruch 1, **dadurch gekennzeichnet, dass** die Bedienlinie (16) einen Kreisbogen beschreibt.

4. Kochfeldsteuerung nach Anspruch 1, **dadurch gekennzeichnet, dass** die Bedienlinie (16) eine gekrümmte oder geschwungene Bahn beschreibt.

5. Kochfeldsteuerung nach einem der Ansprüche 1 bis 4, **dadurch gekennzeichnet, dass** die IR-Fototransistoren (4) und die IR-Sendedioden (6) in einem Gehäuse (8) angeordnet sind.

## Claims

1. Hob controller having a plurality of sensors (2) on an operator control line (16),
**characterized in that** a plurality (N1) of IR phototransistors (4) and a plurality (N2) of IR transmitter diodes (6) are alternately arranged on the operator control line (16), and
the operator control line (16) terminates with an IR phototransistor (4) in each case.

2. Hob controller according to Claim 1, **characterized in that** the operator control line (16) is a straight line.

3. Hob controller according to Claim 1, **characterized in that** the operator control line (16) describes an arc of a circle.

4. Hob controller according to Claim 1, **characterized in that** the operator control line (16) describes a curved or serpentine path.

5. Hob controller according to one of Claims 1 to 4, **characterized in that** the IR phototransistors (4) and the IR transmitter diodes (6) are arranged in a housing (8).

## Revendications

1. Commande de plaque de cuisson avec une pluralité de capteurs (2) sur une ligne de commande (16), **caractérisée en ce qu'**une pluralité (N1) de phototransistors IR (4) et une pluralité (N2) de diodes d'émission IR (6) sont disposés en alternance sur la ligne de commande (16), et la ligne de commande (16) se termine chaque fois par un phototransistor IR (4).

2. Commande de plaque de cuisson selon la revendication 1, **caractérisée en ce que** la ligne de commande (16) est une droite.

3. Commande de plaque de cuisson selon la revendication 1, **caractérisée en ce que** la ligne de commande (16) est un arc de cercle.

4. Commande de plaque de cuisson selon la revendication 1, **caractérisée en ce que** la ligne de commande (16) décrit une trajectoire courbe ou incurvée.

5. Commande de plaque de cuisson selon l'une quelconque des revendications 1 à 4, **caractérisée en ce que** les phototransistors IR (4) et les diodes d'émission IR (6) sont disposés dans un boîtier (8).
